# EUROPÄISCHE PATENTSCHRIFT

(11) **EP 0 730 295 B1**
(45) Veröffentlichungstag und Bekanntmachung des Hinweises auf die Patenterteilung: **02.04.2008**
(21) Anmeldenummer: 96102018.7
(22) Anmeldetag: 12.02.1996
(51) Int. Cl.: H01L 23/495

(54) **Halbleitervorrichtung mit gutem thermischem Verhalten**
Semiconductor device with good thermal behaviour
Dispositif semi-conducteur à bon comportement thermique

(30) Priorität: 28.02.1995 DE 19506958
(43) Veröffentlichungstag der Anmeldung: 04.09.1996
(73) Patentinhaber: Infineon Technologies AG, 81669 München (DE)
(72) Erfinder: Pape, Heinz, Dipl.-Phys., D-85609 Aschheim (DE); Hubrich, Frank, Dipl.-Ing. (FH), D-93186 Pettendorf (DE)
(74) Vertreter: Schweiger, Martin

(56) Entgegenhaltungen:
- US-A- 4 797 726
- US-A- 4 952 999
- US-A- 5 021 864
- US-A- 5 336 639
- PATENT ABSTRACTS OF JAPAN vol. 008, no. 161 (E-257), 26.Juli 1984 -& JP 59 061055 A (TOSHIBA KK), 7.April 1984,
- PATENT ABSTRACTS OF JAPAN vol. 009, no. 061 (E-303), 19.März 1985 -& JP 59 201451 A (ROOMU KK), 15.November 1984,
- PATENT ABSTRACTS OF JAPAN vol. 018, no. 673 (E-1647), 19.Dezember 1994 -& JP 06 268146 A (TOSHIBA CORP), 22.September 1994,
- PATENT ABSTRACTS OF JAPAN vol. 013, no. 301 (E-785), 11.Juli 1989 -& JP 01 080051 A (HITACHI LTD), 24.März 1989,

## Beschreibung

Die Erfindung betrifft eine Halbleitervorrichtung mit einem Halbleiterchip und einem damit verbundenen Systemträger, dessen Insel eine Öffnung aufweist.

Halbleiterchips werden zum Schutz vor Zerstörung und Umwelteinflüssen sowie zur besseren Handhabbarkeit im Gehäuse montiert. Bevorzugte Bauform für Massenprodukte ist das Plastikgehäuse. Dabei wird der Halbleiterchips zunächst mit einem Systemträger verbunden. Dieser Systemträger besteht aus einem Rahmen, in den üblicherweise ein inselförmiger Chipträger sowie Anschlüsse für das fertige Produkt vorgesehen sind. Die Verbindung des Halbleiterchips mit dem Systemträger, d.h. mit der den Chip tragenden Insel, erfolgt typischerweise durch eine Klebung oder eine Legierung. Nach der Montage des Halbleiterchips werden dessen einzelne Anschlußpunkte mit den Anschlüssen des Trägerrahmens z. B. mit Bonddrähten verbunden. Danach werden der Halbleiterchip und die Anschlüsse des Anschlußrahmens so umspritzt, daß der Halbleiterchip vollständig gekapselt ist und die Anschlüsse des Gehäuses elektrisch und mechanisch zugänglich sind. Die nicht benötigten Teile des Anschlußrahmens (lead frame) werden danach durch Stanzen entfernt. Das Gehäuse besteht üblicherweise aus einer härtenden Kunststoff-Preßmasse.

Standardisierte Plastikgehäuse werden immer dünner. Die derzeit bereits eingesetzte TSOP-Bauform (thin small outline package) hat noch eine Gehäusedicke von 1 mm. Gleichzeitig werden die in die Gehäuse eingebauten Chips größer. Bei Chipabmessungen von größer 10 x 10 mm² sind Gehäusebauformen bis 20 x 20 mm² vorgesehen (TQFP - thin quad flat package). Bei dünnen Plastikgehäusen ist ein Stabilisierungseffekt der Plastikumhüllung reduziert. Da die Verbindung des Chips mit der Insel und das Umspritzen mit Preßmasse bei Temperaturen von mindestens 180°C erfolgt, spielen deshalb bei Halbleitervorrichtungen mit großen lateralen Abmessungen und extrem dünnen Gehäusen die thermischen Ausdehnungskoeffizienten der beteiligten Materialien eine wesentliche Rolle. Idealerweise müßten alle Ausdehnungskoeffizienten gleich groß sein, damit beim Abkühlen der Vorrichtung kein Bimetalleffekt auftreten kann und sich der Chip-Systemträgerinsel-Verbund nicht verbiegen kann.

Tatsächlich sind jedoch die Ausdehnungskoeffizienten der Hauptmaterialien stark unterschiedlich. Silizium hat einen thermischen Ausdehnungskoeffizienten von 3, die Preßmasse des Gehäuses von etwa 17 und ein typisches Inselmaterial wie Kupfer ebenfalls von etwa 17, jeweils in Einheiten ppm/K. Als zulässige Gehäuseverbiegung werden maximal 30 µm als akzeptabel angesehen, um die Koplanarität dieser Anschlüsse des fertigen Bauelements bei der Weiterverarbeitung, d.h. beim Löten sicherzustellen.

Eine Möglichkeit zur Verbesserung des Durchbiegeverhaltens besteht in der Verwendung von thermomechanischen besser an Silizium angepaßte Systemträgerinseln, beispielsweise NiFe-Legierungen, wie sie aus der DE-A-42 31 705 bekannt sind. Dem stehen jedoch die zunehmenden Integrationsdichten und Taktraten der Chips entgegen, die zu höheren Verlustleistungen führen. Die Wärmeabfuhr und damit die Wärmeleitfähigkeit der NeFe-Legierungen ist 10 bis 20 mal schlechter als bei KupferLegierungen. Zwar vergrößert sich der Wärmewiderstand eines Bauelements beim Wechsel des Leedframematerials von Kupferauf Nickel-Eisen-Legierungen nicht entsprechend der Unterschiede in den Wärmeleitfähigkeitszahlen. Selbst wenn jedoch kritische Temperaturen nicht überschritten werden, verringern höhere Chiptemperaturen die Zuverlässigkeit und Lebensdauer des gesamten Bauelements. Für die Wärmeabfuhr von Schaltungen mit hoher Verlustleistung sind dann spezielle Gehäuse mit eingelegtem Wärmeverteiler (heat slug) oder mit Kühlkörpern notwendig, was teuer und kompliziert herzustellen ist.

Aus den US-A-4,952,999 und US-A-5,150,193 sind Systemträgerinseln mit Schlitzen bekannt. Das letztere Dokument zeigt außerdem einen Systemträger mit einer zentralen Öffnung, deren Durchmesser jedoch kleiner als die lateralen Chipabmessungen sind und deren Fläche erheblich kleiner als die Chipfläche ist. Beide Möglichkeiten führen zu unakzeptablen Gehäusedurchbiegungen.

Die US 4,797,726 offenbart ebenfalls eine Chipinsel mit Öffnungen, die so angeordnet sind, dass die Chipinsel mehrere Teile aufweist. Die Teile sind über verformbare Bereiche miteinander verbunden.

Der Erfindung liegt deshalb die Aufgabe zugrunde, eine Halbleitervorrichtung mit einem Verbund aus einem Halbleiterchip und einer Systemträgerinsel anzugeben, die sowohl hinsichtlich des thermomechanischen als auch des Wärmeabfuhrverhaltens verbessert ist.

Diese Aufgabe wird durch die Merkmale des unabhängigen Patentanspruchs gelöst.

Der Erfindung liegt die Erkenntnis zugrunde, daß bei großen Chips die Insel für die Wärmeabfuhr nur eine geringe vergleichsweise Bedeutung hat, daß jedoch die Chipträgerinsel nicht beliebig verkleinert werden kann, da sich ansonsten bei der Montage des Chips auf dem Systemträger unstabile Verhältnisse bilden. Insbesondere kann eine Verkantung des Chips zu fehlender Planarität des Chip-Systemträger-Verbundes führen. Die Erfindung ermöglicht eine sichere plane Montage des Chips auf der Insel mit einer guten Wärmeabfuhr auch für kleine Chips, bei denen die Systemträgerinsel eine bedeutende Rolle für die Wärmeabfuhr spielt, und eine geringe Gehäusedurchbiegung des fertigen Produkts.

Ausbildungen der Erfindung sind in Unteransprüchen gekennzeichnet. Die Erfindung wird nachfolgend anhand von Ausführungsbeispielen näher beschrieben.
Es zeigen:
FIG 1 bis 4 schematische Darstellungen eines Systemträgers mit einem für den zu montierenden Chip vorgesehenen Bereich, wobei die Ausführungsbeispiele der Figuren 3 und 4 erfindungsgemäß sind,
FIG 5 einen Querschnitt durch ein Bauelement zur Verdeutlichung der Erfindung.

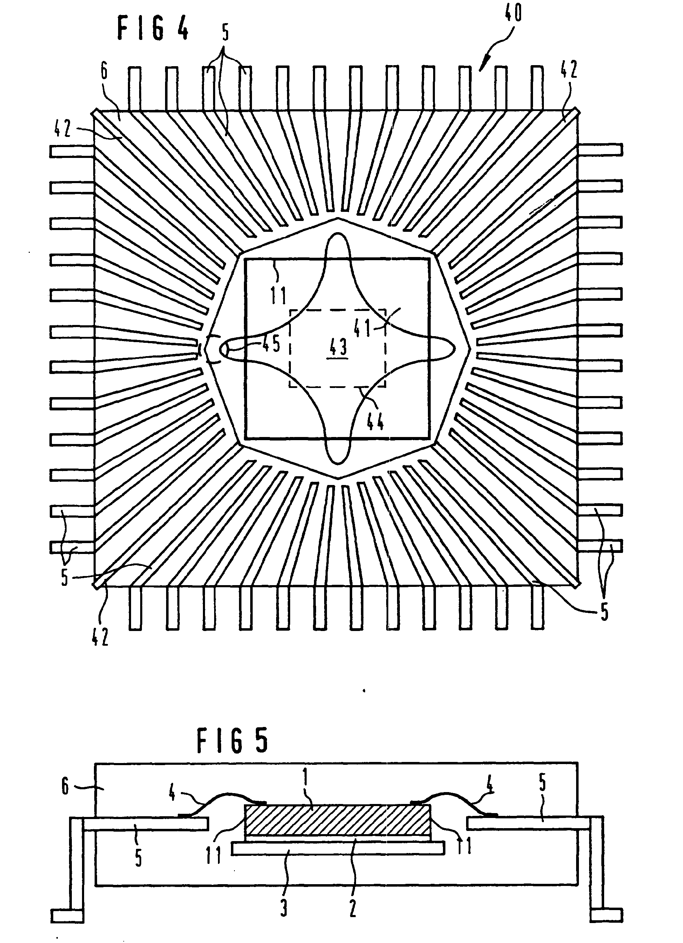

Gemäß FIG 5 ist ein Halbleiterchip 1 mit den Rändern 11 mit Hilfe einer Verbindung 2, beispielsweise eines Klebstoffes, mit einer Systemträgerinsel frei verbunden. Der Chip 1 wird mit Hilfe von Bonddrähten 4 elektrisch mit Anschlüssen 5 verbunden, die nach dem Umspritzen der Anordnung mit einer Preßmasse 6 zur Weiterverarbeitung der Vorrichtung frei zugänglich sind.

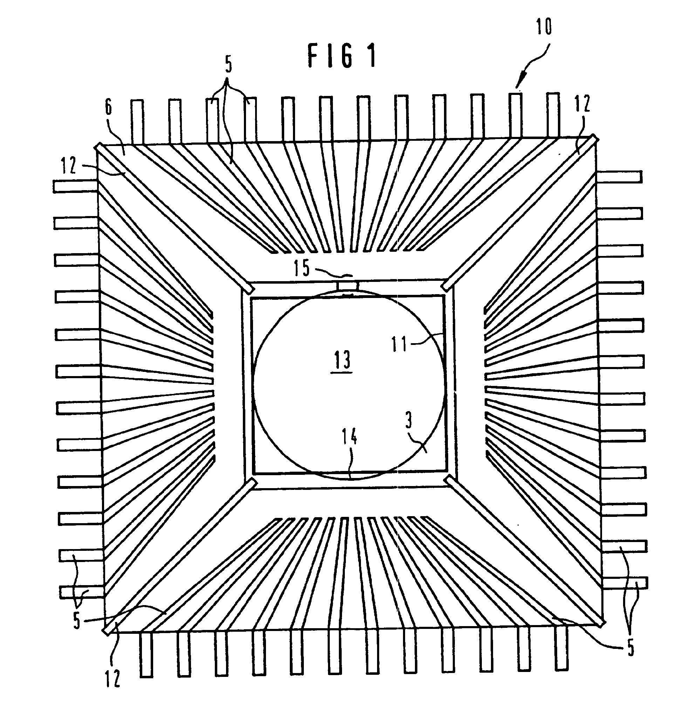

FIG 1 zeigt eine schematische Draufsicht auf einen Schnitt durch eine Anordnung 10, gemäß FIG 5 etwa in Höhe der Chipträgerinsel 3, wobei die Ränder 11 des Chips 3 sowie die Anschlüsse 5 mit eingezeichnet sind. Die Chipträgerinsel 3 ist an schmalen Diagonalträgern 12 befestigt, mit denen die Chipträgerinsel vor dem Ausstanzen der nicht mehr benötigten Teile des Leiterrahmens an letzterem befestigt war. Die Chipträgerinsel 3 hat eine großflächige zentrale Öffnung 13, die an zwei Seiten des Chips über den Chiprand hinausragt. Da im Ausführungsbeispiel die Öffnung etwa kreisförmig und der Chip rechtwinklig ausgebildet ist, ist der Durchmesser der Öffnung größer als die kürzere Seite des Halbleiterchips. FIG 1 zeigt eine Öffnung mit einem Durchmesser, der etwa der Länge der Längsseite des Chips entspricht. Es ist jedoch auch möglich, den Durchmesser etwas kleiner oder etwas größer als die Längsseite des Chips zu wählen. Im letzteren Fall wäre die Öffnung an allen Seiten des Chips breiter als dieser. Im Ausführungsbeispiel bleibt der gestrichelt umrandete Stegbereich 15 der Systemträgerinsel 3 ohne jeden Kontakt zum Chip.

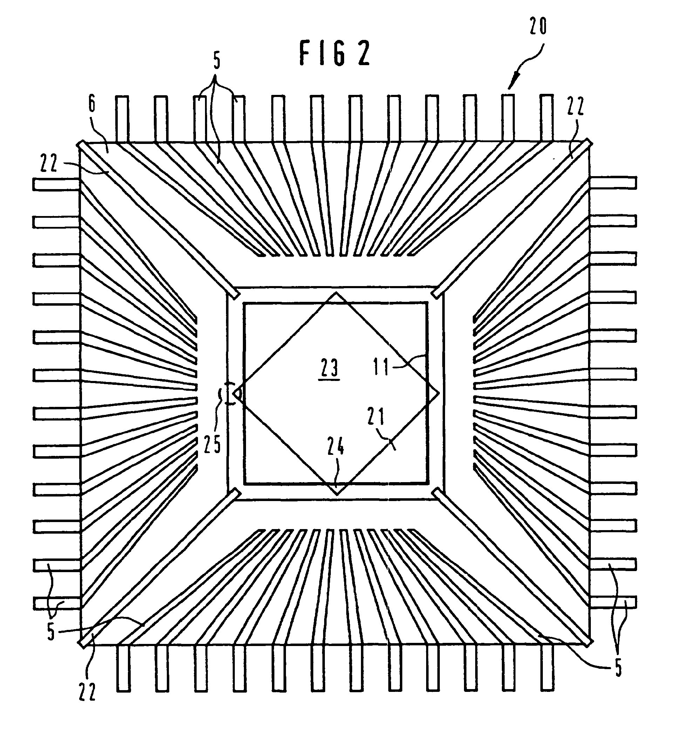

In der Anordnung 20 nach FIG 2 ist die Chipträgerinsel 21 an äußeren Streifen 22 befestigt und hat eine rechteckförmige Öffnung 23, die so gegenüber dem Halbleiterchip mit einem Rand 11 gedreht ist, daß die Ecken 24 der Öffnung über die Längsseiten der Chipöffnung hinausragen. In diesem Fall ist die Öffnung an allen Längsseiten des Halbleiterchips breiter als der Halbleiterchip. Es verbleiben stegförmige Bereiche 25, die an den Längsseiten des Halbleiterchips nicht vom Chip abgedeckt sind.

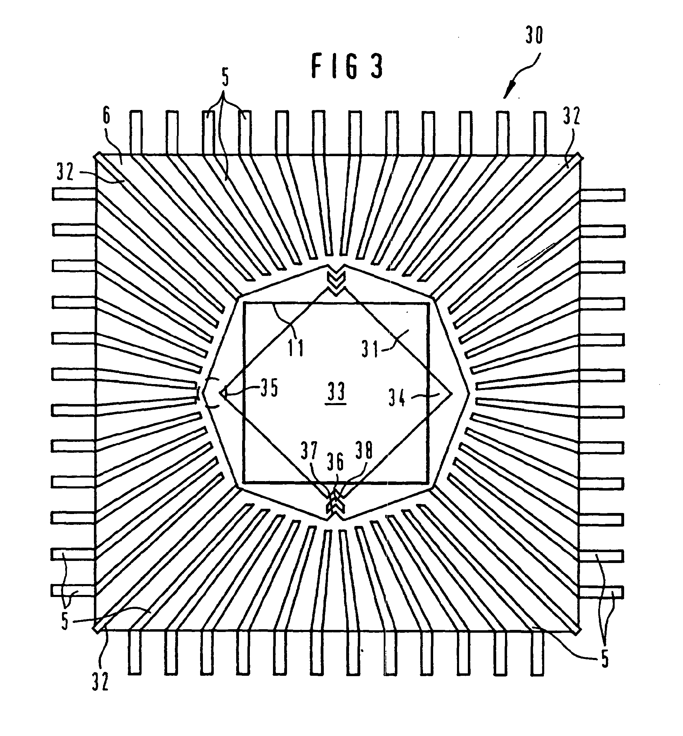

In der Anordnung 30 gemäß FIG 3 ist die äußere Umrandung der Chipträgerinsel 31 achteckig. Die Öffnung 33 ist dagegen etwa rechteckförmig und ähnlich wie bei FIG 2 gegenüber dem Chip so gedreht, daß die Ecken 34 der Öffnung an den Längsseiten des Chiprandes 11 liegen. Auch in diesem Fall verbleiben stegförmige Bereiche 35 an den Längsseiten des Halbleiterchips, die diesen nicht berühren. In FIG 3 sind an zwei Längsseiten des Chips im verbleibenden Stegbereich des Systemträgers 31 zusätzliche Öffnungen 36 vorgesehen, die von zwei schmalen Stegen 37 und 38 sowie von weiteren zwei Bereichen des Systemträgers begrenzt sind. Die Stege 37 und 38 sind abgewinkelt, im Ausführungsbeispiel in Richtung auf den Halbleiterchip, so daß sich durch die Elemente 36 bis 38 ein Dehnungsbereich für die Chipträgerinsel ergibt, wenn sich der Chip quer zu den beiden gegenüberliegenden Dehnungsbereichen ausdehnt.

FIG 4 zeigt eine weitere Anordnung 40, bei der die Öffnung 43 der Systemträgerinsel 41 in Art eines Kreuzes ausgebildet ist, dessen Öffnungsspitzen in Richtung der Längsseiten des Halbleiterchips zeigen. Diese Ausführungsform eignet sich besonders zur Verwendung auch mit kleinen Chips, dessen etwa minimale Größe durch die gestrichelte Linie 44 angedeutet ist. Die Anordnung hat den Vorteil, daß im Vergleich zu den Ausführungsbeispielen der Figuren 1 - 3 noch kleinere Chipgrößen verwendet werden können. Bei einer erfindungsgemäßen Vorrichtung kann lediglich ein Systemträger bzw. eine Systemträgerinsel für eine Vielzahl unterschiedlicher Chipgrößen verwendet werden.

Bevorzugt wird als Material für den leadframe bzw. für die Systemträgerinsel eine Kupferlegierung verwendet. Die Systemträgerinsel ist so ausgebildet, daß durch die Öffnung unter dem montierten Chip möglichst wenig Inselmaterial verbleibt. Die Öffnung kann ausgestanzt oder geätzt werden. Die erfin dungsgemäße Vorrichtung zeichnet sich dadurch aus, daß der Halbleiterchip nicht mehr vollflächig, sondern nur noch im Bereich seiner Ecken und eventuell in einem möglichst schmalen Randbereich auf dem Systemträger aufliegt bzw. mit diesem verbunden ist. Dadurch können außerhalb des Chipbereichs in der Systemträgerinsel Dehnungsbereiche vorgesehen werden, deren Dehnung keine Rückwirkung auf die Dehnung des Chips hat.

Die außerhalb der Chipumrandung liegenden Stegbereiche können grundsätzlich auch vollständig entfallen, so daß die vier Verbindungsbereiche der Systemträgerinsel mit dem Chip an dessen Ecken vollständig voneinander getrennt sind. Voraussetzung ist eine hinreichende mechanische Stabilität der Inselteile. Dies ist insbesondere dann gegeben, wenn Anschlüsse direkt mit den Inselteilen verbunden bleiben und deshalb neben der Inselaufhängung zusätzlich eine Stabilisierung der Inselbereiche gegeben ist. Es ist in diesem Fall möglich, die Eckbereiche der Systemträgerinsel bereits vor dem Die-Bonden aufzutrennen.

Die in FIG 3 gezeigten Dehnungsbereiche 36 bis 38 können so ausgelegt sein, daß sie bei schwacher termomechanischer Belastung als Sollbruchstelle reißen, so daß einzelne Bereiche, insbesondere die vier Eckbereiche der Systemträgerinsel vollständig voneinander getrennt sind. Die in FIG 3 und FIG 4 gezeigte Ausführungsform mit einer 8-eckigen Grundform der Systemträgerinsel hat den besonderen Vorteil, daß sie den meist schräg zurückgesetzten Anschlüssen 5 in minimalem Abstand folgt und die schlecht wärmeleitende Plastikzone 6 zwischen dem Inselrand und den Anschlußspitzen so dünn wie möglich gehalten wird.

Die erfindungsgemäße Vorrichtung hat den weiteren Vorteil, daß die beim Abkühlen auftretenden thermomechanischen Zugkräfte der Insel gegenüber dem Chip verringert und lange gerade Wirkungslinien der Zugkräfte verkürzt oder sogar unterbrochen werden. Insbesondere über die langen Chipdiagonalen und möglichst weitgehend auch entlang der Chipränder wird durch die erfindungsgemäße Vorrichtung ein durchgängiger Kraftaufbau verhindert. Es versteht sich von selbst, daß die Erfindung nicht auf die in Ausführungsbeispielen gezeigten Ausführungsformen, insbesondere nicht auf PQFP-Bauformen beschränkt ist, sondern sich auch auf andere Plastikbauformen übertragen läßt.

Der entscheidende Vorteil der Erfindung gegenüber bisher bekannten Anordnungen besteht darin, daß als Systemträger Material keine Nickel-Eisen-Legierung, sondern eine KupferLegierung verwendet werden kann. Dadurch läßt sich ohne Vergrößerung oder sogar mit einer Verringerung der thermomechanischen Biegung der Halbleitervorrichtung eine erheblich verbesserte Wärmeableitung erreichen, ohne daß ein wärmeverteiler oder eine Wärmeleitplatte in das Gehäuse eingelegt werden oder ohne daß ein Kühlkörper am Gehäuse angebracht werden muß. Schließlich hat die Erfindung den Vorteil, daß sich der Chip in stabiler Weise auf dem Systemträger befestigen läßt und gleichzeitig ein Systemträger für eine Mehrzahl von unterschiedlichen Chipgrößen verwendet werden kann.

## Patentansprüche

1. Halbleitervorrichtung (30, 40) mit einem Halbleiterchip (3) und einem damit verbundenen Systemträger, dessen Insel (31, 41) eine Öffnung (33, 43) aufweist, die großflächig zentral angeordnet und an mindestens zwei Längsseiten des Halbleiterchips (3) breiter ist als der Halbleiterchip (3),
wobei die Insel (31, 41) eine achteckige Grundform aufweist.

2. Vorrichtung (30, 40) nach Anspruch 1,
worin die Öffnung (33, 43) an jeder Längsseite breiter als der zugeordnete Rand des Halbleiterchips (3) ist.

3. Vorrichtung (30, 40) nach Anspruch 1 oder Anspruch 2,
worin die Insel (31, 41) im Bereich der über den Chiprand hinausragenden Öffnung (33, 43) als Dehnungsbereich (36 bis 38) ausgebildet ist.

4. Vorrichtung (30) nach einem der vorhergehenden Ansprüche,
worin die Insel (31) im Bereich der über den Chiprand hinausragenden öffnung (33) aufgetrennt ist.

5. Vorrichtung (40) nach einem der vorhergehenden Ansprüche,
worin die Insel (41) die Form einer zentralen gerundeten Öffnung (43) aufweist.

6. Vorrichtung (30) nach einem der Ansprüche 1 bis 4,
worin die Insel (31) eine rautenförmige Öffnung (33) aufweist.

7. Vorrichtung (40) nach einem der Ansprüche 1 bis 4,
worin die Insel (41) eine zentrale kreuzförmige oder sternförmige Öffnung (43) aufweist.

8. Halbleitervorrichtung (30, 40) mit einem Halbleiterchip (3) und einem damit verbundenen Systemträger, dessen Insel (31, 41) eine Öffnung (33, 43) aufweist, nach einem der Ansprüche 1 bis 8,
worin der Halbleiterchip (3) allein in seinen Eckbereichen mit der Insel verbunden ist.

9. Vorrichtung (30, 40) nach einem der Ansprüche 1 bis 8,
worin die Insel (31, 41) aus Kupfer oder aus einer Kupferlegierung besteht.

## Claims

1. Semiconductor device (30, 40) comprising a semiconductor chip (3) and a system carrier connected thereto, the island (31, 41) of which has an opening (33, 43) which is arranged centrally over a large area and is wider than the semiconductor chip (3) on at least two longitudinal sides of the semiconductor (3),
wherein the island (31, 41) has an octagonal basic form.

2. Device (30, 40) according to Claim 1,
wherein the opening (33, 43) is wider than the assigned edge of the semiconductor chip (3) on each longitudinal side.

3. Device (30, 40) according to Claim 1 or Claim 2,
wherein the island (31, 41) is formed as an expansion region (36 to 38) in the region of the opening (33, 43) projecting beyond the chip edge.

4. Device (30) according to one of the preceding claims,
wherein the island (31) is separated in the region of the opening (33) projecting beyond the chip edge.

5. Device (40) according to one of the preceding claims,
wherein the island (41) has the form of a central rounded opening (43).

6. Device (30) according to one of Claims 1 to 4,
wherein the island (31) has a rhombic opening (33).

7. Device (40) according to one of Claims 1 to 4,
wherein the island (41) has a central cross-shaped or star-shaped opening (43).

8. Semiconductor device (30, 40) comprising a semiconductor chip (3) and a system carrier connected thereto, the island (31, 41) of which has an opening (33, 43), according to one of Claims 1 to 8,
wherein the semiconductor chip (3) is connected to the island solely in its corner regions.

9. Device (30, 40) according to one of Claims 1 to 8,
wherein the island (31, 41) is composed of copper or a copper alloy.

## Revendications

1. Dispositif semiconducteur (30, 40) comprenant une puce en semiconducteur (3) et un support de système relié avec celle-ci dont l'îlot (31, 41) présente une ouverture (33, 43) qui est disposée sur une grande surface centrale et qui est plus large que la puce en semiconducteur (3) sur au moins deux côtés longitudinaux de la puce en semiconducteur (3), l'îlot (31, 41) présentant une forme de base octogonale.

2. Dispositif (30, 40) selon la revendication 1, l'ouverture (33, 43) sur chaque côté longitudinal étant plus large que le bord associé de la puce en semiconducteur (3).

3. Dispositif (30, 40) selon la revendication 1 ou la revendication 2, l'îlot (31, 41) étant réalisé sous la forme d'une zone de dilatation (36 à 38) dans la zone de l'ouverture (33, 43) qui dépasse au-delà du bord de la puce.

4. Dispositif (30) selon l'une des revendications précédentes, l'îlot (31) étant séparé dans la zone de l'ouverture (33) qui dépasse au-delà du bord de la puce.

5. Dispositif (40) selon l'une des revendications précédentes, l'îlot (41) présentant la forme d'une ouverture (43) arrondie centrale.

6. Dispositif (30) selon l'une des revendications 1 à 4, l'îlot (31) présentant une ouverture (33) en forme de losange.

7. Dispositif (40) selon l'une des revendications 1 à 4, l'îlot (41) présentant une ouverture (43) centrale en forme de croix ou en forme d'étoile.

8. Dispositif semiconducteur (30, 40) comprenant une puce en semiconducteur (3) et un support de système relié avec celle-ci dont l'îlot (31, 41) présente une ouverture (33, 43) selon l'une des revendications 1 à 8, la puce en semiconducteur (3) étant reliée avec l'îlot uniquement dans ses zones de coin.

9. Dispositif (30, 40) selon l'une des revendications 1 à 8, l'îlot (31, 41) étant constitué de cuivre ou d'un alliage de cuivre.
